Europäisches Patentamt

European Patent Office

Office européen des brevets

(19)

(11) Numéro de publication: **0 170 568**
**B1**

(12) **FASCICULE DE BREVET EUROPEEN**

(45) Date de publication du fascicule du brevet: 05.09.90

(51) Int. Cl.⁵: **H 03 K 3/78,** H 03 K 5/15

(21) Numéro de dépôt: **85401319.0**

(22) Date de dépôt: **28.06.85**

(54) Générateur de séquences prédéterminées de signaux logiques combinés.

(30) Priorité: **03.07.84 FR 8410515**

(43) Date de publication de la demande:
**05.02.86 Bulletin 86/06**

(45) Mention de la délivrance du brevet:
**05.09.90 Bulletin 90/36**

(84) Etats contractants désignés:
**BE DE GB IT NL**

(56) Documents cités:
**EP-A-0 058 108**
**FR-A-2 280 254**
**FR-A-2 507 414**

**ELECTRONICS DESIGN, vol. 27, no. 12, 7 juin 1979, page 120, Rochelle Park, US; P.R. HARDAKER: "EPROMs are the building blocks for expandable universal timing generator"**

(73) Titulaire: **COMMISSARIAT A L'ENERGIE ATOMIQUE**
**31/33, rue de la Fédération**
**F-75015 Paris (FR)**

(72) Inventeur: **Laviron, André**
**15, rue des Champs Viaux Daix**
**F-21121 Fontaine Les Dijon (FR)**

(74) Mandataire: **Mongrédien, André et al**
**c/o BREVATOME 25, rue de Ponthieu**
**F-75008 Paris (FR)**

Courier Press, Leamington Spa, England.

## Description

La présente invention concerne un générateur de séquences prédéterminées de signaux logiques combinés.

Ce générateur permet d'obtenir des séquences prédéterminées de signaux logiques combinés de niveau 1 et 0 obtenus, dans certaines conditions prédé terminées, à des instants successifs de chaque séquence.

L'invention s'applique à la simulation de tous les systèmes logiques fonctionnant à partir de la réception de signaux logiques de niveau 0 ou 1. Ces signaux logiques de niveau 0 ou 1 appliqués sur les différentes entrées d'un circuit de simulation, correspondent par exemple à la simulation de la défaillance ou de la réparation des composants du circuit simulé. Ce générateur peut aussi s'appliquer à l'étude de la défaillance ou du bon fonctionnement de tout système à plusieurs composants, (mécaniques ou hydrauliques par exemple), en fonction de la défaillance ou du bon fonctionnement de chacun de ses composants; la défaillance ou le bon fonctionnement des composants du système peuvent intervenir soit simultanément, soit séparément. L'étude de la défaillance du système se fait en associant le générateur de l'invention avec un simulateur logique dont les composants logiques représentent les composants du système simulé; les signaux logiques de niveau 0 ou 1 sont appliqués sur les entrées des composants logiques du simulateur pour simuler la défaillance ou la réparation des composants correspondants du système. Pour chacune des combinaisons des signaux logiques fournis sur les sorties du générateur de l'invention, la réponse du simulateur (niveau logique du signal de sortie du simulateur) est analysée, afin de savoir s'il s'agit d'une combinaison de signaux logiques entraînant ou non la défaillance du système. La liste des combinaisons de signaux logiques de niveau 0 ou 1 associée aux réponses du simulateur, permet d'analyser le système simulé, pour des études de fiabilité.

On sait que dans les centrales nucléaires, les avions, les ensembles de recherches pétrolières, ... il est nécessaire d'utiliser des systèmes de commande ou de sécurité présentant une grande fiabilité, qui pour cette raison, présentent tres souvent des voies redondantes. Ces voies redondantes permettent d'éviter que toute panne de l'un des composants de l'une des voies, empêche le système de déclencher l'action de sécurité ou de commande souhaitée. Ces voies redondantes permettent aussi de faciliter la réparation ou le contrôle d'une ou plusieurs voies sans arrêter l'action de sécurité ou de commande souhaitée.

Différentes méthodes ont été utilisées pour analyser la fiabilité de systémes de commande ou de sécurité. Malheureusement, ces méthodes utilisent généralement le principe dit "d'arbre de défaillance", qui nécessite l'usage de calculateur de puissance lorsque le systéme à contrôler est complexe. Ces difficultés sont décrites dans l'article de P.K. ANDOW intitulé "Difficulties in fault tree synthesis for process plant" paru dans la revue IEEE transactions reliability, vol. R29, avril 1980, pages 2 à 9.

Les difficultés qui apparaissent dans l'analyse de fiabilité d'un systéme à partir de l'arbre de défaillance de ce système, peuvent être surmontées grâce à l'utilisation de circuits de simulation câblés, représentant ce système. Ces circuits sont décrits, par exemple dans l'article intitulé "Verification of fault tree analysis" publié par "Electric Power Research Institute", dans la revue EPRI-NP-1570, volumes 1 et 2, mai 1981. Ces circuits de simulation permettent d'éviter la conception d'un arbre de défaillance d'un système; ils sont cependant très limités en performances, puisqu'ils permettent l'étude de fiabilité de systèmes comportant au plus 20 composants.

Plus récemment a été développé un générateur de signaux logiques combinés permettant d'étudier la fiabilité de systèmes à partir de circuits de simulation. Ce générateur est décrit dans l'article de A. LAVIRON intitulé "ESCAF, failure simulation and reliability calculation device", second national reliability conference, Birmingham (England), volume 2, mars 1979, page 6C/4/1—6 C/4/10. Ce générateur de signaux logiques combinés permet d'étudier la fiabilité de systèmes complexes, par l'intermédiaire de simulateurs logiques. Il fournit sur N de ses sorties, toutes les combinaisons possibles de P signaux logiques de niveau 1 et de N-P signaux logiques de niveau 0. Ces signaux logiques sont appliqués, en fonction des tests recherchés de fiabilité, sur les entrées des composants du circuit de simulation de manière à simuler soit le bon fonctionnement de chaque composant (niveau logique 1 du signal appliqué sur une entrée du composant), soit la défaillance de chaque composant (niveau logique 0 appliqué sur l'entrée de ce composant). Ces signaux logiques simulant la défaillance ou le bon fonctionnement d'un ou plusieurs composants du circuit de simulation permettent d'observer sur la sortie de ce circuit, si la défaillance ou le bon fonctionnement d'un ou plusieurs composants du circuit, provoque la défaillance ou le bon fonctionnement de ce circuit. Le générateur de combinaison précité permet de simuler des systémes comprenant plus de 400 composants. Toutefois, il ne permet que la simulation d'évènements (défaillance ou bon fonctionnement de composants d'un circuit) survenant simultanément, pour des études dans lesquelles l'ordre d'arrivée des événements n'intervient pas. Ce générateur qui présente un progrès évident par rapport aux systèmes de simulation utilisant des ordinateurs de puissance (de type GRAY I par exemple) ne permet toutefois pas de simuler des évènements (défaillance ou bon fonctionnement des composants d'un circuit survenant successivement. Or il apparaît souvent nécessaire, dans une étude de fiabilité d'un système, de faire intervenir des séquences de défaillance ou de bon fonctionnement, dans lesquelles l'ordre d'arrivée des évènements présente une grande importance pour l'étude de fiabilité. Les techniques de simulation (arbre de défaillance) qui étaient utilisées avec le générateur précité, ne peuvent alors pas être mises en oeuvre. Ces techniques connues nécessitent la construction d'un diagramme de MARKOV, en général très complexe, qui, pour un système comportant de nombreux composants, est impossible à concevoir.

La présente invention a pour but de remédier aux inconvénients des dispositifs connus permettant d'étudier la fiabilité de système complexes. Elle permet notamment de surmonter les inconvénients concernant les limitations de performances, le coût et la complexité des dispositifs connus, et notamment ceux qui utilisent des ordinateurs de puissance. Le générateur de l'invention permet d'appliquer aux systèmes étudiés, des événements survenant en séquences. Elle permet également d'améliorer les performances du générateur de combinaisons mentionné plus haut, notamment en rendant possible l'étude de fiabilité de systémes très complexes; ces systèmes sont notamment ceux qui font intervenir des événements séquentiels avec des conditions spéciales validant ou non certains événements à certaines périodes de la séquence: par exemple, on ne peut simuler un refus de démarrage d'un moteur qu'au moment ou celui-ci reçoit effectivement un ordre de démarrage.

Le générateur séquentiel de l'invention permet d'étudier, grâce à un circuit de simulation, la plupart des systèmes qui nécessitent une étude de fiabilité.

L'invention a pour objet un générateur de séquences prédéterminées de signaux logiques combinés comprenant les caractéristiques de la revendication 1.

Selon une autre caractéristique, nombre des instants successifs $t_i$ varie de 1 à m, m étant un nombre entier inférieur ou égal à p; $q_i$ étant une valeur entière comprise entre 1 et p.

Selon une autre caractéristique, le générateur comprend en outre des moyens logiques de contrôle reliés aux R sorties des multiplexeurs et aux moyens de commande, comportant des moyens pour avorter toute séquence pour laquelle, à tout instant $t_i$, deux signaux de sortie parmi les R signaux de sorties des multiplexeurs sont simultanément au niveau logique 1, alors qu'ils ne devraient pas l'être.

Selon une autre caractéristique les moyens, de contrôle (C) comportent des moyens pour avorter toute séquence pour laquelle, à tout instant $t_i$, aucun signal de niveau logique 1 n'est fourni sur l'une quelconque de R sorties des multiplexeurs à un instant $t_i$ d'une séquence, alors que des signaux de niveau logique 1 sont fournis à un instant $t_{i+k}$, avec $k \geqslant 1$.

Selon une autre caractéristique, les moyens logiques de contrôle comprennent une entrée de commande d'invalisation par les moyens de commande, d'une combinaison initiale de signaux logiques présents sur les N sorties du générateur de signaux logiques combinés.

Selon une autre caractéristique, les moyens logiques de contrôle (C) comprennent en outre une entrée (EVENEXT) et une entrée (INHIB) de commande de mise au niveau logique 0 des signaux de sortie des multiplexeurs, lorsqu'à un instant $t_i$ la séquence de signaux prévue à cet instant sur les sorties des multipleurs, ne doit pas être utilisée.

Selon une autre caractéristique, les moyens de contrôle (C) comprennent des moyens d'enregistre ment de signaux (VALCOL), qui combinés avec les signaux fournis sur les R sorties des multipleurs (MX1, . . ., MXR) permettent d'invalider toute séquence ne correspondant pas à une séquence de signaux souhaitée sur les sorties des multiplexeurs.

Les caractéristiques et avantages de l'invention ressortiront mieux de la description qui va suivre donnée en référence aux dessins annexés dans lesquels:

la figure 1 représente schématiquement un systéme dont la fiabilité peut être étudiée grâce au générateur de l'invention,

la figure 2 représente schématiquement un circuit de simulation du système de la figure 1,

les figures 3A et 3B représentent schématiquement, un générateur de séquences de signaux logiques combinés conforme à l'invention.

Le générateur de séquences prédéterminées de signaux logiques conforme à l'invention est plus particulièrement destiné à l'étude de la défaillance ou du bon fonctionnement d'un circuit logique mais comme on va le voir, il peut permettre, par analogie, grâce à un circuit logique de simulation, l'étude du bon fonctionnement ou de la défaillance de systèmes divers, tels que des circuits hydrauliques par exemple.

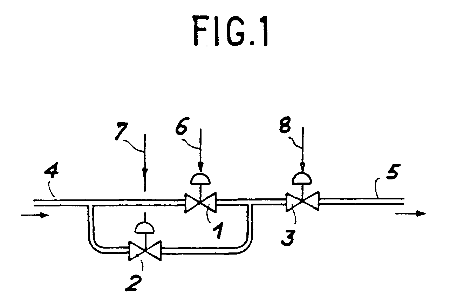

La figure 1 représente schématiquement un circuit hydraulique dont la fiabilité peut être étudiée grâce au générateur de l'invention, par l'intermédiaire d'un circuit de simulation qui sera décrit plus loin en détail. Ce circuit hydraulique permet d'établir par exemple, la circulation d'un fluide entre un conduit amont 4 et un conduit aval 5, grâce à trois vannes pneumatiques 1, 2, 3 dont l'ouverture ou la fermeture peut être commandée par la présence ou l'absence d'air comprimé dans les conduits de commande 6, 7, 8. Dans ce circuit, on considère que les vannes constituent les seuls composants qui peuvent être, soit en état de défaillance, soit en état de bon fonctionnement. Le circuit hydraulique considéré est défaillant si le fluide n'est pas transmis dans le conduit aval 5. Lorsque seules les vannes 1 et 2 sont défaillantes, le fluide ne passe plus du conduit amont 4 vers le conduit aval 5; il en est de même lorsque les vannes 1 et 3 sont défaillantes. Dans ces deux cas, le circuit est mis en état de défaillance lorsque les vannes précitées sont défaillantes.

Lorsque seules les vannes 1 et 3 sont en bon fonctionnement, le fluide passe d'amont en aval; le circuit reste donc en état de bon fonctionnement lorsque seules les vannes 1 et 3 sont en état de bon fonctionnement.

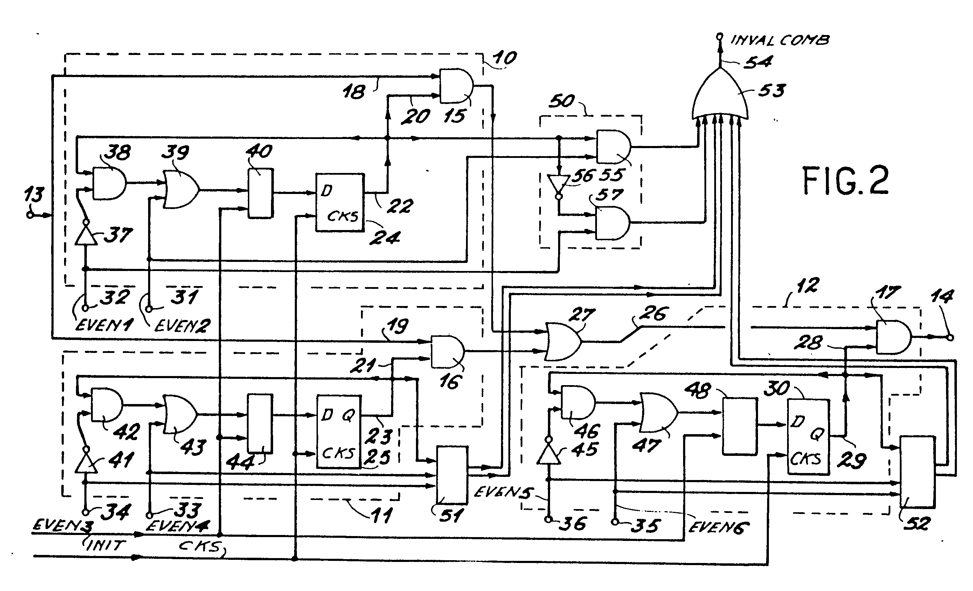

La figure 2 représente schématiquement un circuit logique équivalent permettant de simuler le circuit hydraulique de la figure 1. C'est sur des entrées de certains des composants de ce circuit que sont

3

EP 0 170 568 B1

appliquées, comme on le verra plus loin en détal les séquences de signaux fournies par le générateur de séquences de signaux logiques combinés de l'invention. Ces signaux séquentiels de niveaux logiques 0 ou 1, appliqués sur des entrées de certains des composants du circuit de simulation, permettent de simuler électroniquement, soit la défaillance, soit le bon fonctionnement des composants correspondants du système hydraulique. Sur le schéma de la figure 2, les ensembles 10, 11, 12, de circuits logiques permettent de simuler soit la défaillance, soit le bon fonctionnement des vannes 1, 2, 3, de la figure 1. Ces ensembles de circuits logiques sont constitués de manière que si un signal de niveau logique 1 est appliqué sur une entrée 13 du circuit de simulation, un signal de niveau logique 1 doit apparaître sur la sortie 14 de ce circuit. Le signal de niveau logique 1 appliqué à l'entrée simule en fait l'arrivée du fluide dans le, conduit 4, en amont du systéme hydraulique de la figure 1. Sur la sortie 14 du circuit de simulation, ce signal de niveau logique 1 permet de déduire que le système simulé est en état de bon fonctionnement et qu'il laisse passer le fluide arrivant à son entrée, quel que soit l'état de défaillance ou de bon fonctionnement d'un ou plusieurs des composants du circuit hydraulique simulé.

Les ensembles logiques de simulation 10, 11, 12 comprennent respectivement des portes logiques de type "ET" 15, 16, 17. Chacune de ces portes comprend deux entrées. Les entrées 18, 19 des portes 15, 16, reçoivent le signal de niveau logique 1 appliqué sur l'entrée 13 du circuit, pour simuler l'arrivée du fluide dans le conduit 4 du circuit de la figure 1. Les autres entrées 20, 21, des portes 15, 16 sont reliées respectivement aux sorties 22, 23 de mémoire 24, 25 constituées par des bascules de type D. Les portes 15, 16 fournissent un signal de niveau logique 1 sur leur sortie lorsque les bascules D 24, 25 reliées à leurs entrées 20, 21 fournissent un signal de niveau logique 1 sur leurs sorties Q 22, 23. Inversement, ces portes fournissent un signal de niveau logique 0 lorsque les bascules de type D fournissent un signal de niveau logique 0. En fait, le niveau logique 1 du signal fourni par les bascules de type D est représentatif du bon fonctionnement de la vanne correspondante du système simulé. Le niveau logique 0 de ce signal est au contraire représentatif de la défaillance ou du mauvais fonctionnement de cette vanne.

De la même manière, la porte ET 17, de l'ensemble logique 12 correspondant à la vanne 3 du circuit hydraulique de la figure 1, comprend une entrée 26 qui est reliée à la sortie d'une porte OU 27. Cette porte OU comprend deux entrées qui sont reliées respectivement aux sorties des portes ET 15, 16. Elle est équivalente au branchement de l'entrée de la vanne 3 avec les sorties des vannes 1, 2 du circuit hydraulique. L'autre entrée 28 de la porte ET 17 est reliée à la sortie 29 d'une mémoire 30, constituée elle aussi par une bascule de type D. Comme précédemment, la présence d'un signal de niveau logique 1 sur la sortie 29 de la bascule 30, exprime le bon fonctionnement de la vanne correspondante 3 du circuit hydraulique simulé. Au contraire, la présence d'un signal de niveau logique 0 sur la sortie 29, exprime le mauvais fonctionnement ou la défaillance de la vanne 3.

Un signal de niveau logique 1 est obtenu sur la sortie 22 de la bascule 24 et simule le bon fonctionnement de la vanne 1 correspondante, lorsqu'un signal EVEN2 de niveau logique 1, est appliqué sur l'entrée 31 de l'ensemble de simulation 10 en même temps qu'un signal d'horloge CKS est appliqué à la bascule 24; un signal de niveau logique 1 est bien entendu appliqué sur l'entrée 13 du circuit de simulation. Un signal de niveau logique 0 est obtenu sur la sortie 22 de la bascule 24 et simule la défaillance de la vanne 1, lorsqu'un signal EVEN1 de niveau logique 1, est appliqué sur l'entrée 32 de l'ensemble 10, en même temps qu'un signal d'horloge CKS est appliqué à la bascule 24.

De la même manière, les ensembles de simulation 11, 12, comprennent respectivement des entrées 33, 34 et 35, 36. Des signaux EVEN4, EVEN6, de niveau logique 1 appliqués respectivement sur des entrées 33, 35 simulent le bon fonctionnement des composants correspondants 2, 3 du circuit hydraulique, Des signaux EVEN3, EVEN5, de niveau logique 1 appliqués respectivement sur les entrées 34, 36 simulent la défaillance des composants correspondants 2, 3 du circuit hydraulique. Des signaux d'horloge CKS sont respectivement appliqués aux bascules 25 et 30.

Dans l'ensemble 10, le signal EVEN1 de niveau logique 1, simulant la défaillance de la vanne 1, est appliqué à un inverseur 37, dont la sortie est reliée à une entrée d'une porte ET38. Une autre entrée de cette porte est reliée à la sortie 22 de la bascule 24. La sortie de la porte ET38 est reliée à une entrée d'une porte OU39, qui reçoit sur une autre entrée, le signal EVEN2 de niveau logique 1 lorsque le bon fonctionnement de la vanne 1 doit être simulé. La sortie de la porte OU39 est reliée à une entrée d'un multiplexeur 40. Une autre entrée de ce multiplexeur reçoit à l'initialisation, un signal INIT provenant du générateur de séquences de l'invention, comme on le verra plus loin en détal. La sortie du multiplexeur 40 est reliée à l'entrée D de la bascule 24. Une autre entrée de cette bascule reçoit les signaux d'horloge CKS, provenant du générateur de séquences de signaux logiques combinés de l'invention.

De la même maniére, l'ensemble de simulation 11 comprend un inverseur 41, une autre porte ET42, une porte OU43, un multiplexeur 44; l'ensemble de simulation 12 comprend lui aussi un inverseur 45, une autre porte ET46, une porte OU47 et un multiplexeur 48. Ces éléments sont reliés de la même façon que dans l'ensemble 10.

On voit que dans le circuit de simulation qui vient d'être décrit, le niveau logique du signal sur la sortie 14 de ce circuit dépend du niveau logique des signaux séquentiels EVEN1, EVEN2, EVEN3, EVEN6, appliqués sur les entrées correspondantes de simulation de ce circuit, par le générateur de séquences de l'invention. Le fonctionnement de ce circuit de simulation va maintenant être expliqué de manière plus détaillée.

Au début d'une séquence de signaux logiques combinés appliqués sur les entrées 31, 32, ... , 36 du

4

circuit de simulation, un signal INIT d'initialisation, de niveau logique 1, fourni par le générateur de l'invention est appliqué sur les entrées des multiplexeurs 40, 44, 48. Ce signal de niveau logique 1 se retrouve sur les sorties correspondantes des multiplexeurs et il est appliqué sur les entrées D des bascules 24, 25, 30. Toutes ces bascules de type D mémorisent alors le niveau logique 1 à la première impulsion d'horloge CKS, fournie en même temps que le signal INIT. Les sorties Q, 22, 23, 29 des bascules 24, 25, 30 fournissent alors respectivement des signaux de niveau logique 1. Le signal apparaissant à la sortie 14 du circuit de simulation présente alors le niveau logique 1. Les entrées 31—36 du circuit de simulation sont reliées, comme on le verra plus loin en détail, aux sorties du générateur de séquences de l'invention. L'initialisation du circuit de simulation ayant été effectuée comme indiqué plus haut, si le générateur de séquence fournit par exemple un signal EVEN3, de niveau logique 1 sur l'entrée 34 du circuit de simulation en même temps qu'une impulsion d'horloge CKS, la bascule 25 correspondant à la vanne 2 du système simulé, fournit sur sa sortie 23 un signal de niveau logique 0, représentant la défaillance de la vanne 2. En appliquant successivement les signaux EVEN1, EVEN2, ... , EVEN6 sur les entrées correspondantes du circuit de simulation, à des instants successifs $t_i$ déterminés par l'horloge du générateur de l'invention, on simule donc la succession d'évènements correspondants (défaillances ou bon fonctionnement) qui peuvent survenir dans le fonctionnement des composants du circuit hydraulique simulé. En observant le niveau logique du signal sur la sortie 14 du circuit de simulation, et en connaissant la séquence émise à chaque instant $t_i$, il est donc possible de déterminer les séquences qui conduisent à la défaillance ou au bon fonctionnement du circuit hydraulique simulé.

C'est ainsi par exemple que dans le systéme de la figure 1 la défaillance peut être provoquée à la suite d'une séquence d'évènements qui peut être la suivante:

défaillance de la vanne 1,
réparation ou bon fonctionnement de la vanne 1,
défaillance de la vanne 2,
défaillance de la vanne 1.

Cette séquence correspond, pour le circuit de simulation, à l'application d'un signal EVEN1 de niveau logique 1 sur l'entrée 32, à l'instant $t_i$, puis à l'application d'un signal EVEN2 de niveau logique 1 sur l'entrée 31 à l'instant $t_i+1$, puis à l'application d'un signal EVEN3 de niveau logique 1 sur l'entrée 34, à l'instant $t_i+2$, puis enfin à l'application d'un signal EVEN1 de niveau logique 1 sur l'entrée 32 à l'instant $t_i+3$.

La défaillance du système peut également être obtenue par la seule défaillance de la vanne 3. Dans ce cas, la séquence est constituée tout simplement par l'application d'un signal EVEN5 de niveau logique 1 sur l'entrée 36 du circuit de simulation, à un instant unique $t_i$.

Le circuit de simulation représenté sur cette figure comprend aussi des ensembles logiques 50, 51, 52, identiques, dans lesquels seul l'ensemble logique 50 a été représenté en détail. Ces ensembles logiques sont reliés aux entrées d'une porte OU53. Cette porte fournit sur sa sortie 54, un signal INVAL COMB, qui est appliqué au générateur de séquences de l'invention, lorsqu'une séquence ne doit pas être prise en compte par suite de la non observation de certains critéres. C'est ainsi par exemple que dans le circuit de simulation qui vient d'être décrit, un signal INVAL COMB de niveau logique 1 apparaît sur la sortie 54 de la porte OU53, lorsqu'un signal de niveau logique 1 est appliqué sur une entrée de défaillance d'un composant (EVEN1, EVEN3 ou EVEN5 par exemple), et que le composant est déjà considéré comme défaillant. De la même manière, le signal INVAL COMB est mis au niveau logique 1, si un signal de niveau 1 est appliqué sur une entrée (EVEN2, EVEN4 ou EVEN6) alors que le composant correspondant est déjà considéré comme étant en bon fonctionnement, la mémoire d'enregistrement de cet état ayant déjà sa sortie au niveau logique 1. Le signal INVAL COMB est appliqué sur une entrée correspondante du générateur de l'invention, comme on le verra plus loin en détail.

L'ensemble logique 50 comprend une porte ET55 dont les entrées sont reliées respectivement à l'entrée de simulation 31 et à la sortie 22 de la bascule 24. La sortie de la porte ET55 est reliée à une entrée de la porte OU53. Cet ensemble comprend aussi un inverseur 56 dont l'entrée est reliée à la sortie de la bascule 24 et dont la sortie est reliée à une entrée d'une porte ET57. Une autre entrée de la porte ET57 est reliée à l'entrée de simulation 32. La sortie de la porte ET57 est reliée à une autre entrée de la porte OU53. Les ensembles 51 et 52 sont constitués de la même façon. On n'a représenté sur la figure que leurs entrées reliées aux circuits 11, 12 correspondants, et leurs sorties reliées à des entrées de la porte OU53.

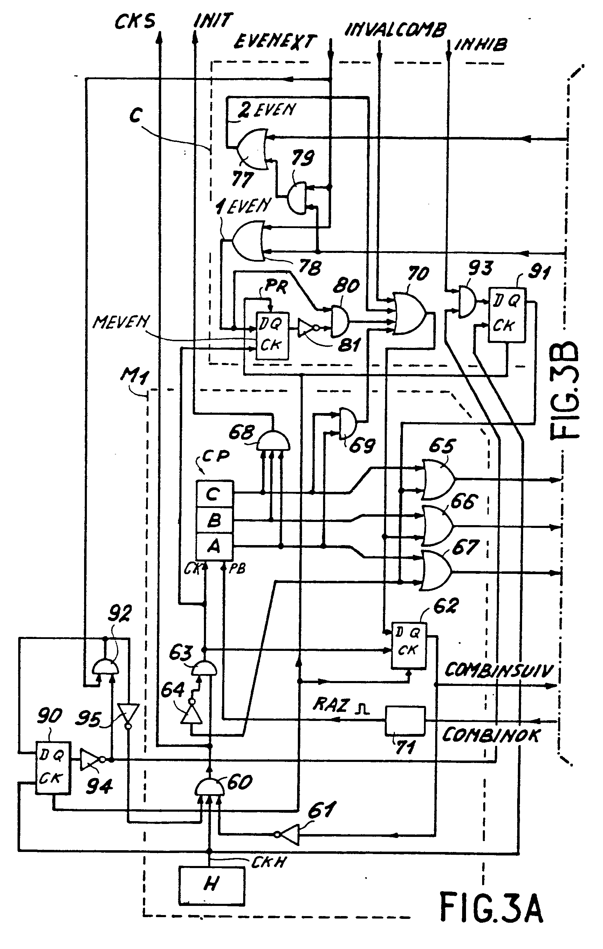

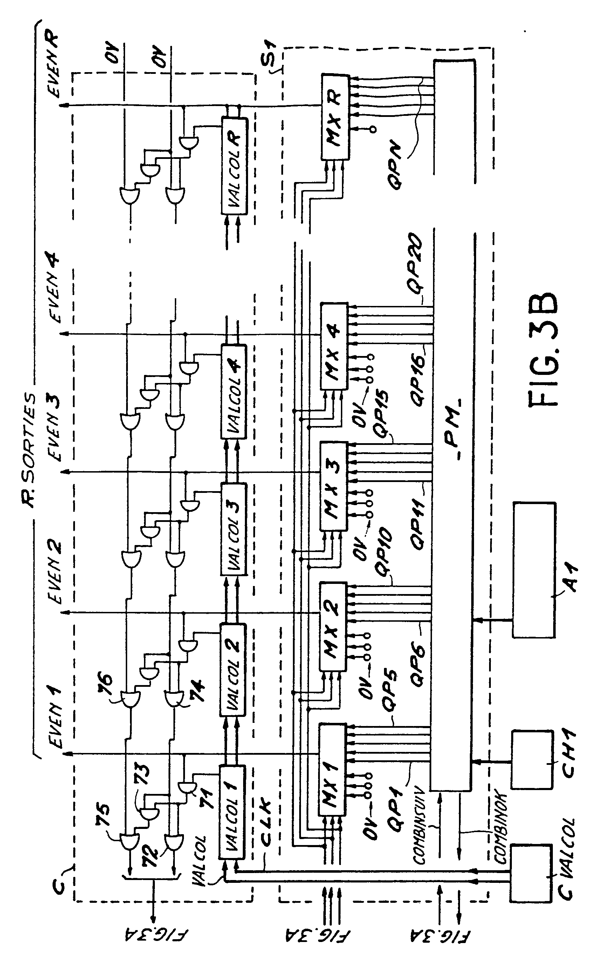

Les figures 3a et 3b représentent schématiquement un générateur de séquence prédétérminé de signaux logiques combinés, conforme à l'invention.

Ce générateur comporte des moyens séquentiels S1 qui présentent un nombre R de sorties EVEN1, EVEN2, EVEN3, ... , EVENR; ces moyens sont capables de fournir à chaque instant $t_i$ d'une succession d'instants et pour chaque séquence prédéterminée de signaux combinés, un nombre $q_i$ de signaux de niveau logique 1, fournis sur $q_i$ sorties et un nombre $R-q_i$ de signaux de niveau logique 0, fournis sur $R-q_i$ sorties. La somme des nombres $q_i$ est égale à un nombre prédéterminé p de signaux de niveau logique 1, dans une combinaison initiale enregistrée dans ces moyens séquentiels, comme on le verra plus loin en détail. Cette combinaison initiale correspond à la séquence prédéterminée que l'on cherche à obtenir et comprend p signaux de niveau logique 1, ainsi que des signaux de niveau logique 0. D'une manière générale, et comme on le verra plus loin en détail, le nombre des instants successifs $t_i$ varie de 1 à m, m étant un nombre entier inférieur ou égal à p, tandis que $q_i$ est une valeur entière comprise entre 1 et p.

Le tableau ci-dessous permettra de mieux comprendre sur un exemple particulier, l'obtention d'une séquence prédéterminée sur les sorties du générateur de séquences de l'invention.

| $t_i$ | EVEN1 | EVEN2 | EVEN3 | EVEN4 | $q_i$ |
|-------|-------|-------|-------|-------|-------|
| $t_1$ | 1 | 0 | 0 | 0 | $q_1=1$ |
| $t_2$ | 0 | 0 | 1 | 0 | $q_2=1$ |
| $t_3$ | 1 | 1 | 1 | 0 | $q_3=3$ |

Dans ce tableau, on a représenté les niveaux logiques 1 ou 0 des signaux fournis sur les sorties EVEN1, EVEN2, EVEN3, EVEN4, du générateur, aux instants successifs $t_i$ ($t_1$, $t_2$, $t_3$), lorsque i présente les valeurs successives 1, 2, 3. On a également indiqué les valeurs de $q_1$, $q_2$, $q_3$, qui indiquent, pour chaque instant $t_i$, le nombre de sorties du générateur de séquences qui sont à un niveau 1.

On remarque que dans la séquence prédéterminée choisie en exemple, le nombre de signaux logiques de niveau 1, est $q_1=1$ à l'instant $t_1$, $q_2=1$ à l'instant $t_2$ et $q_3=3$ à l'instant $t_3$. La somme $q_1+q_2+q_3$ des valeurs $q_i$ est égale à 5. La valeur p=5 correspond à un nombre prédéterminé p choisi de signaux logiques de niveau 1; ces p signaux de niveau 1 sont pris dans une combinaison initiale de N signaux comprenant comme on le verra plus loin en détail, N-p signaux de niveau logique 0 et p signaux logiques de niveau 1 fournis simultanément et non pas en séquence, cette combinaison initiale de signaux logiques est enregistrée, comme on le verra plus loin, dans les moyens séquentiels du générateur de l'invention.

Ce générateur comprend aussi des moyens CH1, VALCOL, reliés aux moyens séquentiels S1, pour initialiser ces moyens séquentiels et pour qu'ils fournissent les signaux de niveau logique 1 et 0 aux instants successifs $t_i$ correspondant à la séquence prédéterminée, à partir de la combinaison initiale enregistrée dans les moyens séquentiels. Ces moyens d'initialisation seront décrits plus loin en détail.

Le générateur comprend aussi des moyens de commande M1 reliés aux moyens séquentiels S1 pour que ceux-ci fournissent aux instants successifs $t_i$, sur les R sorties EVEN1, EVEN2, ... , EVENR, les $q_i$ signaux de niveau logique 1 et les $R-q_i$ signaux de niveau logique 0. La somme des nombres $q_i$, pour l'ensemble des instants $t_i$ de la séquence est égale à p et est fixée par la combinaison initiale de signaux appliqués aux moyens séquentiels. Il est bien évident que les nombres R, $q_i$ et p mentionnés plus haut, sont des nombres i entiers. Enfin, le générateur comprend des moyens d'arrêt A1, reliés aux moyens séquentiels S1, pour arrêter la fourniture de signaux sur les R sorties du générateur de l'invention, aprés une séquence prédéterminée de signaux combinés.

Les moyens séquentiels S1 comprennent un générateur PM de signaux logiques combinés présentant N sorties capables de fournir les combinaisons initiales (p signaux de niveau 1 et N-p signaux de niveau 0) correspondant aux séquences prédéterminées que l'on souhaite obtenir. Les p sorties de ce générateur sont représentées en QP1 ... QPn sur la figure. Chaque combinaison initiale est formée de p signaux de niveau logique 1 produits sur p sorties du générateur et de N-p signaux de niveau logique 0, produits sur N-p sorties de ce générateur. Le générateur PM capable de fournir les combinaisons initiales de signaux, est par exemple celui qui est décrit dans FR—A—2 498 849, au nom du même demandeur. Les moyens A1 qui permettent d'arrêter les moyens séquentiels et qui sont reliés à ce générateur, sont ceux qui sont décrits en exemple dans cette demande de brevet. Les moyens CH1, reliés au générateur et qui permettent d'initialiser les moyens séquentiels sont aussi ceux qui sont décrits en exemple dans la demande de brevet précitée. Les moyens CVALCOL qui sont reliés aux moyens CH1, et qui permettent eux aussi d'initialiser les moyens séquentiels seront décrits plus loin en détail.

Les moyens séquentiels S1 comprennent aussi des multiplexeurs MX1, MX2, ... ,MXR qui reçoivent simultanément sur N de leurs entrées, les p signaux de niveau logique 1 et les N-p signaux de niveau logique 0 correspondant aux combinaisons initiales. Ces multiplexeurs fournissent sur R sorties, les $q_i$ signaux de niveau logique 1 et les $R-q_i$ signaux de niveau logique 0, en un certain nombre d'instants successifs $t_i$ de chaque séquence. Les moyens de commande M1 sont reliés au générateur PN de signaux combinés et au multiplexeur MX1 ... MXR.

Le nombre des instants successifs $t_i$ varie de 1 à m, m étant un nombre entier inférieur ou égal à p. En effet, dans une séquence qui comporterait p signaux de niveau logique 1 et pour laquelle un seul signal de niveau logique 1 serait fourni à chaque instant $t_i$, un nombre p d'instants $t_i$ serait nécessaire pour décrire toute une séquence comprenant p signaux de niveau logique 1.

Le générateur de séquences de l'invention comprend aussi des moyens logiques de contrôle C qui seront décrits plus loin en détail. Ces moyens logiques de contrôle sont reliés aux R sorties des multiplexeurs ainsi qu'aux moyens de commande M1. Ils permettent d'avorter toute séquence pour laquelle à tout instant $t_i$, deux signaux de sortie parmi les R signaux fournis par les multiplexeurs, sont simultanément au niveau logique 1 alors qu'ils ne devraient pas l'être dans la simulation que l'on désire effectuer. Ces moyens de contrôle permettent aussi d'avorter toute séquence pour laquelle, à tout instant $t_i$, aucun signal de niveau logique 1 n'est fourni sur l'une quelconque des R sorties des multiplexeurs, alors que des signaux de niveau logique 1 sont fournis à un instant $t_{i+k}$, avec $k \geq 1$.

La structure de ces moyens de contrôle ainsi que leur fonctionnement seront décrits plus loin en détail.

Ces moyens comprennent notamment une entrée INVALCOMB de commande d'invalidation, par l'intermédiaire des moyens de commande M1, d'une combinaison initiale de signaux logiques présents sur les N sorties du générateur PM de signaux logiques combinés. Cette entrée peut être reliée à la sortie correspondante du circuit de simulation de la figure 2.

Les moyens logiques de contrôle (C) comprennent aussi des entrées EVENEXT et INHIB, qui, en fonction des besoins de la simulation à effectuer et comme on le verra plus loin en détail, reçoivent des signaux permettant d'arrêter ou non la présentation d'une combinaison de signaux sur les sorties du générateur séquentiel. Ces moyens de contrôle comprennent aussi une entrée VALCOL reliée à des moyens d'enregistrement de, signaux, qui, combinés avec les signaux fournis par les multiplexeurs, permettent d'invalider toute séquence ne correspondant pas à une séquence souhaitée. Cette possibilité sera décrite ultérieurement.

Les moyens de commande M1 fournissent au circuit de simulation décrit plus haut, des signaux d'horloge CKS et d'initialisation INIT dans des conditions qui seront décrites plus loin. Ces moyens de commande fournissent également au générateur PM un signal COMBINSUIV, lorsqu'une séquence de signaux prédéterminée a été décrite et que le générateur PM doit présenter la combinaison initiale suivante, permettant de décrire une autre séquence prédéterminée. Ces moyens de commande M1 reçoivent du générateur PM, un signal COMBINOK, lorsqu'une nouvelle combinaison initiale permettant de décrire une séquence prédéterminée est présente sur les sorties QP1,..., QPN du générateur PM de combinaisons initiales.

La structure et le fonctionnement des moyens essentiels du générateur de l'invention vont maintenant être décrits de manière plus détaillée.

Les moyens de commande M1 comprennent une horloge H fournissant des impulsions CKH sur l'entrée d'une porte ET60. Cette porte est reliee par une autre entrée à la sortie d'un inverseur 61. L'entree de cet à inverseur est reliée à la sortie Q d'une bascule monostable 62, dont le rôle sera décrit plus loin en détail, qui fournit notamment le signal COMBINSUIV appliqué au générateur PM. La sortie de la porte 60 fournit des impulsions d'horloge CKS au circuit de simulation décrit plus haut. Cette sortie est aussi reliée à une entrée d'une porte ET63, dont une autre entrée est reliée à la sortie d'un inverseur 64. La sortie de la porte ET63 est reliée à une entrée d'horloge CK d'un compteur CP à trois éléments binaires, pour lui appliquer les impulsions d'horloge CKS. Les bascules du compteur sont désignées par A, B, C. La sortie de la porte ET63 est aussi reliée à une entrée d'horloge CK de la bascule 62, ainsi qu'à une entrée d'horloge CK d'une mémoire MEVEN, constituée par une bascule de type D. Les sorties du compteur CP sont reliées aux multiplexeurs MX1, MX2,..., MXR, pour que ceux-ci présentent sur une ou plusieurs de leurs sorties EVEN1, EVEN2,..., EVENR, un ou plusieurs des signaux présents sur leurs entrées QP1,..., QPN. Les sorties du compteur CP sont reliées aux multiplexeurs, par l'intermédiaire de portes OU65, 66, 67; ces por' tes peuvent également recevoir, sur une autre entrée, le signal d'inhibition INHIB, Les sorties du compteur CP sont aussi reliées aux entrées d'une porte ET68, dont la sortie fournit le signal d'initialisation INIT appliqué au circuit de simulation décrit plus haut. Enfin, la premiére et la dernière sorties du compteur CP sont reliées aux entrées d'une porte ET69 dont la sortie est reliée à une entrée d'une porte OU70 des moyens de contrôle C. Les moyens de commande M1 comprennent aussi une bascule monostable 71 dont l'entrée reçoit le signal COMBINOK provenant du générateur PM lorsqu'une combinaison initiale prédéterminée est présente sur les sorties de ce générateur de combinaisons PM. La sortie de cette bascule monostable fournit, comme on le verra plus loin en détail, une impulsion RAZ de remise à zéro du compteur CP et de commande de la bascule 62, qui fournit alors le signal COMBINSUIV appliqué au générateur PM pour que celui-ci présente, sur ses sorties une nouvelle combinaison initiale de signaux logiques. La sortie de la porte OU70 des moyens de contrôle C est reliée à l'entrée D de la bascule 62.

Les moyens de contrôle C comprennent des registres à décalage VALCOL1, VALCOL2,..., VALCOL R reliés en série et chargés à l'initialisation du générateur de séquences de signaux logiques. Ces registres sont chargés sur leurs entrées VALCOL, par des signaux provenant des moyens d'initialisation C VALCOL, sous la commande d'impulsions de décalage CLK. Ces registres permettent, comme on le verra plus loin en détail de valider les signaux de sortie des multiplexeurs en fonction de la simulation à effectuer, ou d'invalider certaines séquences qui ne correspondent pas aux séquences souhaitées. Chaque registre tel que le registre VALCOL 1 par exemple, comprend une sortie qui est reliée à une entrée d'une porte ET71 dont une autre entrée est reliée à la sortie du multiplexeur MX1 correspondant des moyens séquentiels. La sortie de cette porte ET71 est reliée, d'une part à une entrée d'une porte OU72, et d'autre part à une entrée d'une porte ET73. Une autre entrée de la porte OU72 et une autre entrée de la porte ET73 sont reliées à la sortie d'une porte OU74 semblable, pour le registre VALCOL 2, à la porte OU72. La sortie de la porte ET73 est reliée à une entrée d'une porte OU75 dont une autre entrée est reliée à la sortie d'une porte OU76, semblable pour le registre VALCOL 2 à la porte OU75. La sortie de la porte OU75 est reliée à une entrée d'une porte OU77. Les portes 71, 72, 73, 75 forment un ensemble logique, dont le rôle sera décrit plus loin en détail, cet ensemble reçoit des signaux provenant du multiplexeur MX1, du registre à décalage VALCOL 1 correspondant, ainsi que des signaux provenant de l'ensemble logique précédent, correspondant au registre à décalage VALCOL 2 et au multiplexeur MX2. Le dernier ensemble, non représenté sur la figure, qui correspond à l'avant-dernier multiplexeur MX(R—1) et à l'avant-dernier registre à décalage VALCOL(R—1) reçoit, sur les entrées des portes OU qui correspondent aux portes OU72, 75, et sur l'entrée de la porte ET correspondant à la porte 73 du premier ensemble, des signaux de niveau logique 0, comme indiqué sur la figure.

La sortie de la porte OU72 est reliée à une entrée d'une porte OU78. Une autre entrée de la porte 78 peut recevoir, dans des conditions qui seront décrites plus loin en détail, le signal EVENEXT. Ce signal peut également être appliqué à une entrée d'une porte ET79, dont la sortie est reliée à une autre entrée de la porte OU77. Une autre entrée de la porte ET79 est reliée à la sortie de la porte OU72. La sortie de la porte OU77 est reliée à une entrée de la porte OU70. La sortie de la porte OU78 est reliée d'une part à l'entrée D de la bascule MEVEN et, d'autre part à une entrée d'une porte ET80. Une autre entrée de la porte 80 est reliée à la sortie d'un inverseur 81. L'entrée de cet inverseur est reliée à la sortie Q de la bascule MEVEN. La sortie de la porte ET80 est reliée à une entrée de la porte OU70.

Les explications qui suivent vont permettre maintenant de mieux comprendre le fonctionnement du générateur de séquences de signaux logiques combinés, qui vient d'être décrit.

Lorsque le générateur de combinaisons initiales PM a émis une combinaison initiale comprenant p signaux de niveau logique 1 et N-p signaux de niveau logique 0, sur ses N sorties QP1,... , QPN, il émet un signal COMBINOK qui est appliqué à la bascule monostable 71. Cette bascule fournit une impulsion qui met au niveau logique 1 les trois bascules A, B, C, du compteur CP. Il en résulte que la porte ET68 fournit un signal INIT de niveau logique qui est appliqué, comme indiqué plus haut, au circuit de simulation pour l'initialiser. Jusqu'à cet instant, aucun signal EVEN1, ... , EVENR n'est fourni sur les sorties des multiplexeurs MX1,... , MXR. Cette inhibition des sorties des multiplexeurs vient du fait que les signaux de sortie du compteur, qui sont appliqués aux entrées de commande (0, 1, 2 ... 6, 7) des multiplexeurs, par l'intermédiaire des portes OU65, 66, 67, sont tous au niveau logique 1. Dans ce cas, c'est l'entrée $O_v$ de chaque multiplexeur qui est sélectionnée car l'entrée n°7 du pultiplexeur reçoit un signal de niveau logique 0.

Lorsque la première impulsion CK de l'horloge H est produite à l'instant $t_0$ (pour i=0), le front montant de cette impulsion provoque l'initialisation du circuit de simulation car le signal INIT est au niveau logique 1 (les 3 entrées de la porte ET68 étant au niveau logique 1).

Pour l'impulsion d'horloge CKS suivante, c'est-à-dire au temps $t_1$ (i=1), les bascules A, B, C du compteur présentent sur leur sortie, des signaux de niveau logique 0; ces signaux commandent les multiplexeurs pour que ceux-ci fournissent sur les sorties EVEN1,... , EVENR, des signaux correspondant respectivement aux signaux appliqués sur les entrées QP5, QP10, QP15,... , QPN de ces multiplexeurs, car l'entrée n°0 de chaque multiplexeur, est sélectionnée. Il est évident que tout autre mode de comptage associé à toute autre façon de commander les multiplexeurs, peut être envisagé.

A l'impulsion d'horloge suivante (correspondant au temps $t_2$ pour i=2, le signal de sortie de la bascule A du compteur est au niveau logique 1 tandis que les signaux de sortie des bascules B et C sont au niveau logique 0. Les multiplexeurs vont alors fournir sur leurs sorties EVEN1, ... , EVENR des signaux correspondant aux signaux appliqués sur leurs entrées QP4, QP9, QP14,... , QPN—1, par le générateur PM de combinaisons initiales.

Aprés le temps $t_5$ (l'exemple de réalisation considéré comprenant des multiplexeurs à 5 entrées) la bascule 62 est actionnée par une nouvelle impulsion d'horloge. En effet, au temps $t_5$, les signaux de sortie des bascules A et C du compteur sont au niveau logique 1 et il en résulte que la sortie de la porte ET69 est elle aussi au niveau logique 1. Ce niveau logique est transmis à la bascule 62 par l'intermédiaire de la porte OU70. Un signal COMBINSUIV de niveau logique 1 apparaît donc à la sortie de la bascule 62. Ce signal est appliqué au générateur de combinaison PM qui fournit alors, sur ses sorties, la combinaison initiale suivante; le générateur de séquences va alors fournir une nouvelle séquence prédéterminée de signaux, à partir de cette nouvelle combinaison initiale. Lorsque le générateur PM est prêt à fournir une nouvelle combinaison initiale, un signal COMBINOK est appliqué à la bascule monostable 71; le signal de sortie de la bascule 71 remet à zéro la bascule 62 dont la sortie était à 1 à la fin de la séquence précédente.

On notera que lorsqu'à la fin d'une séquence, le signal de sortie de la bascule 62 passe au niveau logique 1, l'horloge H est bloquée puisque l'entrée de la porte ET60, qui est reliée à la sortie de l'inverseur 61, est au niveau logique 0.

Un exemple numérique va permettre de mieux comprendre le fonctionnement séquentiel du générateur de l'invention: on suppose par exemple que le générateur de combinaison PM fournit la combinaison initiale de signaux QP3=1, QP10=1, QP14=1, QP19=1 sur 4 de ses sorties, les signaux sur les autres sorties du générateur étant au niveau logique 0. A partir de cette combinaison, le générateur séquentiel va fournir par exemple, sur les sorties EVEN1, EVEN2, EVEN3, EVEN4, les signaux séquentiels prédéterminés suivants: le signal EVEN1 correspondant au signal QP3 de niveau logique 1, est fourni au temps $t_3$. Le signal EVEN2 corespondant au signal QP10 de niveau logique 1 est fourni au temps $t_1$. Le signal EVEN3 correspondant au signal QP14 de niveau logique 1, est fourni au temps $t_2$. Le signal EVEN4 correspondant au signal QP19 de niveau logique 1, est fourni au temps $t_2$.

Cet exemple permet de mieux comprendre qu'à une combinaison initiale donnée de signaux de niveau logique 1 et de niveau logique 0 fournis sur les sorties QP1,... , QPN du générateur de combinaisons PM, correspond sur les sorties du générateur séquentiel une séquence prédéterminée de signaux, fournis aux instants successifs $t_i$.

Les moyens CH1 d'initialisation, sont les mêmes que ceux qui sont décrits dans FR—A—2 498 849 précitée; ces moyens sont associés avec les moyens d'initialisation VALCOL qui permettent, comme on le verra plus loin en détail, d'invalider certaines séquences, sur les sorties des multiplexeurs. Les moyens d'arrêt A1 sont identiques à ceux qui sont décrits dans FR—A—2 498 849.

On va maintenant décrire les moyens qui permettent d'invalider une séquence qui ne correspond pas à une séquence de signaux souhaitée, sur les sorties des multiplexeurs. L'ensemble de registres VALCOL1, ..., VALCOLR permet d'enregistrer autant d'éléments binaires qu'il y a de multiplexeurs. Chaque élément binaire qui est à 1 dans l'un des registres VALCOL1, ..., VALCOLN permet de valider un signal de sortie EVEN1 ou EVEN2, ..., ou EVENR correspondant. La sortie notée 1 EVEN de la porte OU78 est au niveau logique 1, s'il existe au moins un signal EVEN1 ou EVEN2 ... ou EVENR de niveau logique 1 en même temps qu'un élément binaire de valeur 1 dans un registre VALCOL1 ou VALCOL2 ... ou VALCOLR correspondant.

La sortie 2 EVEN de la porte OU77 est au niveau logique 1, s'il existe au moins deux sorties EVEN1 ou EVEN2 ... ou EVENR au niveau logique 1 et que des éléments binaires de valeur 1 se trouvent dans deux des registres VALCOL1 ... VALCOLN correspondant aux deux multiplexeurs dont les sorties sont au niveau logique 1.

La sortie 2 EVEN de la porte 77 permet d'invalider une séquence dans laquelle deux sorties du générateur séquentiel sont au niveau logique 1 alors qu'elles ne devraient pas l'être pour la simulation souhaitée. Dans ce cas, la sortie 2EVEN est au niveau logique 1. La séquence en cours est avortée car l'entrée D de la bascule 62 est alors au niveau 1 et que le signal COMBINSUIV sur la sortie de cette bascule, passe au niveau logique 1. Une nouvelle combinaison initiale est alors présentée sur les sorties du générateur PM.

Les moyens qui viennent d'être décrits permettent d'empêcher l'arrivée simultanée de deux événements (deux niveaux logiques 1 simultanés sur deux sorties du générateur séquentiel). Dans d'autres cas de simulation, ces moyens peuvent être inhibés de façon au contraire, à permettre comme on le verra plus loin, l'arrivée simultanée de deux évènements.

Les moyens de contrôle C comprennent aussi des moyens pour avorter toute séquence dans laquelle, à un instant $t_i$, aucun signal de niveau logique 1 ne serait fourni sur l'une quelconque des R sorties des multiplexeurs, alors que des signaux de niveau logique 1 sont fournis à l'instant $t_{i+k}$. En effet, il ne servirait à rien de décrire une séquence dans laquelle une impulsion d'horloge ne procurerait aucun évènement sur l'ensemble des sorties du générateur séquentiel (toutes les sorties EVEN1, ..., EVENR sont au niveau logique 0). C'est ainsi par exemple, qu'une séquence qui permet d'obtenir le signal INIT à la première impulsion d'horloge puis les signaux EVEN1 et EVEN3 de niveau logique 1, pour la deuxième et la troisième impulsions d'horloge, est équivalente à la séquence qui permet d'obtenir le signal INIT à la première impulsion d'horloge puis le signal EVEN1 (niveau logique 1) à la deuxième impulsion d'horloge, aucun signal à la troisième impulsion d'horloge, et le signal EVEN3 (niveau logique 1) pour la quatrième impulsion d'horloge. La deuxième séquence citée en exemple est équivalente à la première, mais aucun évènement ne se produit à la troisième impulsion d'horloge. Cette séquence présente à la troisième impulsion d'horloge, une perte de temps inutile. Les moyens qui permettent d'avorter ce type de séquence comprennent essentiellement la mémoire MEVEN. Cette mémoire est initialisée à son entrée PR, au niveau logique 1, lors de l'apparition du signal COMBINOK. Dès qu'il y a absence d'évènement (signaux de niveau logique 0 sur toutes les sorties EVEN1, ..., EVENR du générateur séquentiel, pour une impulsion d'horloge la mémoire MEVEN passe, au niveau logique 0. Dans ce cas en effet, le signal de sortie de la porte OU78 est au niveau logique 0. Si après cette absence d'évènement intervient la présence d'un événement, le signal 1EVEN est au niveau logique 1. L'absence d'évènement (signal de sortie de la bascule MEVEN, au niveau logique 0) est détectée par la porte ET80 qui applique, par l'intermédiaire de la porte OU70 sur l'entrée D de la bascule 62, un signal de niveau logique 1. La sortie Q de cette bascule 62 passe alors au niveau 1, vient bloquer l'horloge H, par l'intermédiaire de l'inverseur 61 et de la porte ET60. La séquence en cours est arrêtée, le signal COMBINSUIV de niveau logique 1 commande le générateur de combinaison PM pour que celui-ci fournisse une nouvelle combinaison initiale.

Les moyens de contrôle C comprennent une entrée INVALCOMB, de commande d'invalidation d'une combinaison initiale de signaux logiques, présents sur les sorties du générateur PM. Ce signal de niveau logique 1, peut être appliqué au générateur séquentiel, par le circuit de simulation décrit plus haut, lorsque la séquence ne satisfait pas à certains critéres prédéterminés. Le signal INVALCOMB est appliqué à la bascule 62, par l'intermédiaire de la porte OU70. La sortie de cette bascule qui est alors au niveau logique 1 bloque l'horloge H et commande le générateur PM pour que celui-ci fournisse sur sa sortie une autre combinaison initiale.

L'entrée EVENEXT permet d'arrêter ou non en fonction des besoins de la simulation à effectuer, la présentation d'une combinaison de signaux sur les sorties du générateur séquentiel, en relation avec un signal présenté sur l'entrée INHIB. Les entrées INHIB et EVENEXT sont reliées à des circuits logiques dont les connexions ne seront pas décrites en détail; ces circuits comprennent des bascules D 90, 91, des portes ET 92, 93 et des inverseurs 94, 95.

Lorsqu'un signal de niveau logique 1 est appliqué sur l'entrée EVENEXT, il produit d'une part les signaux 1EVEN et éventuellement 2EVEN décrits plus haut et, d'autre part, il bloque la propagation des signaux d'horloge CKH vers le circuit de simulation (signal CKS) et vers le générateur séquentiel (signal CK), par l'intermédiaire des portes 92, 60 et de l'inverseur 95, la bascule D90 étant initialement au niveau logique 0.

Simultanément, un signal de niveau 0 ou 1 est appliqué sur l'entrée INHIB selon que la simulation en cours nécessite l'application ou non des signaux fournis sur les sorties du générateur séquentiel. Le signal INHIB est mémorisé par la bascule D91 à l'impulsion d'horloge CKH suivante (non transmise au circuit de simulation et au générateur séquentiel). Cette même impulsion provoque un passage du niveau logique 0 au niveau logique 1 de la bascule D90, cette bascule provoque alors la réapparition du signal d'horloge CKS du circuit de simulation et du signal d'horloge CK du générateur séquentiel. Cependant le signal CK n'est effectivement validé que si la bascule 91 est restée au niveau logique 0. La porte ET93 permet la remise à zéro de la bascule 91 à l'impulsion d'horloge suivante car la bascule 90 applique un signal de niveau logique 1 sur l'inverseur 94 dont la sortie est alors à zéro. Le signal INHIB de niveau logique 1 n'est utilisé en fait que lorsque le signal EVENEXT est lui-même au niveau logique 1.

La mémorisation du signal INHIB est nécessaire du fait que le signal INHIB dépend des signaux fournis par le générateur séquentiel et que la présence des signaux délivrés pour ce générateur dépend elle aussi de la présence de ce signal INHIB; cette mémorisation évite toute oscillation due à la présence d'un tel rebouclage.

## Revendications

1. Générateur de séquences prédéterminées de signaux logiques combinés, comprenant un générateur (PM) de signaux logiques combinés présentant N sorties (QP1,..., QPN), capable de fournir des combinaisons initiales de signaux logiques, correspondant auxdites séquences prédéterminées, chaque combinaison initiale étant formée de p signaux de niveau logique 1 produits sur p sorties du générateur de signaux combinés et N-p signaux de niveau logique 0 produits sur N-p sorties du générateur (PM) de signaux combinés, caractérisé en ce qu'il comporte en outre:

des multiplexeurs (MX1,..., MXR) reliés aux sorties du générateur de signaux logiques combinés pour recevoir sur N entrées les p signaux de niveau logique 1 et les N-p signaux de niveau logique 0 correspondant aux combinaisons initiales et fournissant sur R sorties (EVEN1,..., EVNR), $q_i$ signaux de niveau logique 1 et R-$q_i$ signaux de niveau logique 0, à des instants successifs $t_i$ de chaque séquence, la somme des nombres $q_i$ étant égale à un nombre prédéterminé p de signaux de niveau logique 1, les multiplexeurs étant capables d'enregistrer les combinaisons initiales;

des moyens d'initialisation (CH1, VALCOL) reliés au générateur (PM) de signaux combinés et aux multiplexeurs pour les initialiser et pour qu'ils fournissent les signaux de niveaux logiques 1 et 0 aux instants successifs $t_i$ correspondant à la séquence prédéterminée, à partir d'une combinaison initiale enregistrée;

des moyens de commande (M1) reliés au générateur de signaux logiques combinés et aux multiplexeurs pour que ceux-ci fournissent aux instants $t_i$ sur les R sorties, les $q_i$ signaux de niveau logique 1 et les R-$q_i$ signaux de niveau logique 0, la somme des nombres $q_i$ est égale à p, pour l'ensemble des instants $t_i$ de la séquence, les nombres R, $q_i$ et p étant des nombres entiers;

des moyens d'arrêt reliés au générateur (PM) de signaux logiques combinés pour arrêter la fourniture de signaux sur les R sorties, après une séquence prédéterminée de signaux combinés.

2. Générateur de séquence de signaux logiques combinés, selon la revendication 1, caractérisé en ce que le nombre des instants successifs $t_i$ varie de 1 à m, m étant un nombre entier inférieur ou égal à p, $q_i$ étant une valeur entière comprise entre 1 et p.

3. Générateur de séquences de signaux logiques combinés, selon la revendication 1, caractérisé en ce · qu'il comprend en outre, des moyens logiques de contrôle (C) reliés aux R sorties des multiplexeurs et aux moyens de commande, et comportant des moyens pour avorter toute séquence pour laquelle, à tout instant $t_i$, deux signaux de sortie parmi les R signaux de sorties des multiplexeurs Mxl,..., MXR) sont simultanément au niveau logique 1, alors qu'ils ne devraient pas l'être.

4. Générateur de séquences de signaux logiques combinés, selon la revendication 3, caractérisé en ce que les moyens de contrôle (C) comprennent en outre des moyens pour avorter toute séquence pour laquelle, à tout instant $t_i$, aucun signal de niveau logique 1 n'est fourni sur l'une quelconque de R sorties des multiplexeurs à un instant $t_i$ d'une séquence, alors que des signaux de niveau logique 1 sont fournis à un instant $t_{i+k}$, avec $k \geq 1$.

5. Générateur de séquences de signaux logiques combinés, selon la revendication 4, caractérisé en ce que les moyens logiques de contrôle comprennent une entrée (INVALCOMB) de commande d'invalidation par les moyens de commande (M1), d'une combinaison initiale de signaux logiques présents sur les N sorties du générateur (PM) de signaux logiques combinés.

6. Générateur de séquence de signaux logiques combinés, selon la revendication 5, caractérisé' en ce que les moyens logiques de contrôle (C) comprennent en outre, une entrée (EVENEXT) et une entrée (INHIB) de commande de mise au niveau logique 0 des signaux de sortie des multiplexeurs, lorsqu'à un instant $t_i$ la séquence de signaux prévue à cet instant sur les sorties des multiplexeurs, ne doit pas être utilisée.

7. Générateur de séquence de signaux logiques combinés, selon la revendication 3, caractérisé en ce que les moyens de contrôle (C) comprennent des moyens d'enregistrement de signaux (VALCOL), qui combinés avec les signaux fournis sur les R sorties des multiplexeurs (MX1,..., MXR), permettent

# EP 0 170 568 B1

d'invalider toute séquence ne correspondant pas à une séquence de signaux souhaitée sur les sorties des multiplexeurs.

## Patentansprüche

1. Generator vorbestimmter Folgen kombinierter logischer Signale, der einen Generator (PM) kombinierter logischer Signale aufweist, der N Ausgänge (QPI, . . . , QPN) aufweist, der geeignet ist, Startkombinationen logischer Signale zu liefern, die den vorbestimmten Folgen entsprechen, wobei jede Startkombination aus p Signalen des logischen Wertes 1, die von p Ausgängen des Generators kombinierter logischer Signale erzeugt werden, und N-p Signalen des logischen Wertes 0 bestehen, die von N-p Ausgängen des Generators (PM) kombinierter logischer Signale erzeugt werden, dadurch gekennzeichnet, daß er außerdem aufweist:

Multiplexer (MX1, . . . , MXR), die mit den Ausgängen des Generators kombinierter logischer Signale verbunden sind, um auf N Eingängen die p Signale des logischen Wertes 1 und die N-p Signale des logischen Wertes 0, die den Startkombinationen entsprechen, zu empfangen und auf R Ausgängen (EVEN1, . . . , EVNR) $q_i$ Signale des logischen Wertes 1 und R-$q_i$ Signal des logischen Wertes 0 an aufeinander folgenden Zeitpunkten $t_i$ jeder Folge zu liefern, wobei die Summe der Zahlen $q_i$ gleich einer vorbestimmten Zahle p von Signalen des logischen Wertes 1 ist, wobei die Multiplexer geeignet sind, die Startkombinationen aufzunehmen;

Initialisierungsvorrichtungen (CH1, VALCOL), die mit dem Generator (PM) kombinierter Signale und den Multiplexern verbunden sind, um sie zu initialisieren und damit sie Signale der logischen Werte 1 und 0 zu den aufeinanderfolgenden Zeitintervallen $t_i$, die der vorbestimmten Folge entsprechen, von einer aufgenommenen Startkombination zu erzeugen;

Steuervorrichtung (M1), die mit dem Generator kombinierter Signale und der Multiplexern verbunden sind, damit diese zu den Zeitpunkten $t_i$ auf den R Ausgängen die $q_i$ Signale des logischen Wertes 1 und die R-$q_i$ Signale des logischen Wertes 0 erzeugen, die Summe der Zahlen $q_i$ ist gleich p für alle Zeitpunkte $t_i$ der Folge, wobei die Zahlen R, $q_i$ und p ganze Zahlen sind;

Stoppvorrichtungen, die mit dem Generator (PM) kombinierter logischer Signale verbunden sind, um die Signalerzeugung auf den R Ausgängen nach einer vorbestimmten Folge kombinierter Signale anzuhalten.

2. Generator vorbestimmter Folgen kombinierter logischer Signale nach Anspruch 1, dadurch gekennzeichnet, daß die Zahl der aufeinander folgenden Zeitintervalle $t_i$ von 1 bis m variiert, wobei m eine ganze Zahl kleiner oder gleich p ist, wobei $q_i$ einen ganzzahligen Wert zwischen 1 und p hat.

3. Generator vorbestimmter Folgen kombinierter logischer Signale nach Anspruch 1, dadurch gekennzeichnet, daß er außerdem logische Kontrollvorrichtungen (C) aufweist, die mit den R Ausgängen der Multiplexer und den Steuervorrichtungen verbunden sind und Vorrichtungen zum Abbrechen jeder Folge aufweist, für die zu jedem Zeitpunkt $t_i$ zwei Ausgangssignale unter den R Ausgangssignalen der Multiplexer (MX1, . . . , MXR) gleichzeitig auf dem logischen Wert 1 sind, wenn sie es nicht sein dürften.

4. Generator vorbestimmter Folgen kombinierter logischer Signale nach Anspruch 3, dadurch gekennzeichnet, daß die Kontrollvorrichtungen (C) außerdem Vorrichtungen zum Abbrechen jeder Folge aufweist, für die zu jedem Zeitpunkt $t_i$ kein Signal mit dem logischen Wert 1 auf irgendeinem der R Ausgänge der Multiplexer zu einem Zeitpunkt $t_i$ der Folge erzeugt wird, wenn Signale mit dem logischen Wert 1 zu den Zeitpunkten $t_{i+k}$ mit $k \geq 1$ erzeugt werden.

5. Generator vorbestimmter Folgen kombinierter logischer Signale nach Anspruch 4, dadurch gekennzeichnet, daß die logischen Kontrollvorrichtungen einen Steuereingang (INVALCOMB) zum Ungültigmachen durch die Steuervorrichtungen (M1) einer Startkombination logischer Signale, die in den N Ausgängen des Generators (PM) kombinierter logischer Signale vorhanden sind, aufweisen.

6. Generator vorbestimmter Folgen kombinierter logischer Signale nach Anspruch 5, dadurch gekennzeichnet, daß die logischen Kontrollvorrichtungen (C) außerdem einen Eingang (EVENEXT) und einen Eingang (INHIB) zur Steuerung des auf den logischen Wert 0 Setzens der Ausgangssignale der Multiplexer aufweist, falls zu einem Zeitpunkt $t_i$ die zu diesem Zeitpunkt an den Ausgängen der Multiplexer vorgesehene Signalfolge nicht benutzt werden soll.

7. Generator vorbestimmter Folgen kombinierter logischer Signale nach Anspruch 3, dadurch gekennzeichnet, daß die logischen Kontrollvorrichtungen (C) Signalaufnahmevorrichtungen (VALCOL) aufweisen, die zusammen mit den auf den R Ausgängen der Multiplexer (MX1, . . . , MXR) gelieferten Signalen erlauben, jede Folge, die nicht einer auf den Ausgängen der Multiplexer erwünschten Signalfolge entspricht, ungültig zu machen.

## Claims

1. Generator of predetermined sequences of combined logic signals comprising a combined logic signal generator PM having N outputs (QP1 . . . QPN) able to supply initial logic signal combinations, corresponding to said predetermined sequences, each initial combination being formed by p logic level 1 signals produced on p outputs of the combined signal generator and N-p logic zero level signals produced on N-p outputs of the combined signal generator PM, characterized in that it also comprises multiplexers

11

(MX1 . . . . MXR) connected to the outputs of the combined logic signal generator for receiving on N inputs the p logic level 1 signals and the N-p logic level zero signals corresponding to the initial combinations and supplying on R outputs (EVEN1, . . . , EVENR), $q_i$ logic level 1 signals and R-$q_i$ logic level zero signals at successive instants $t_i$ of each sequence, the sum of the numbers $q_i$ being equal to a predetermined number p of logic level 1 signals, the multiplexers being able to record the initial combinations; initialization means (CH1, VALCOL) connected to the combined signal generator (PM) and to the multiplexers for initializing them and in order to supply logic level 1 and zero signals at successive instants $t_i$ corresponding to the predetermined sequence on the basis of an initial recorded combination; control means (M1) connected to the combined logic signal generator and to the multiplexers, for the latter to supply at instants $t_i$ on the R outputs, the q logic level 1 signals and the R-$q_i$ logic level zero signals, the sum of the numbers $q_i$ being equal to p for all the instants $t_i$ of the sequence, the numbers R, $q_i$ and p being integers; and stop means connected to the combined logic signal generator (PM) for stopping the supply of signals of the R outputs following a predetermined sequence of combined signals.

2. Combined logic signal sequence generator according to claim 1, characterized in that the number of successive instants $t_i$ varies from 1 to m, m being an integer equal to or lower than p, whilst $q_i$ is an integral value between 1 and p.

3. Combined logic signal sequence generator according to claim 1, characterized in that it also comprises logic checking means (C) connected to the R outputs of the multiplexers and to the control means having means for aborting any sequence for which, at any instant $t_i$, two output signals from among the R output signals of the multiplexers (MX1 . . . MXR) are simultaneously at logic level 1 when they should not be.

4. Combined logic signal sequence generator according to claim 3, characterized in that the checking means (C) have means for aborting any sequence for which, at any instant $t_i$, no signal of logic level 1 is supplied to any random 1 of the R outputs of the multiplexers at an instant $t_i$ of a sequence, whereas signals of logic level 1 are supplied at an instant $t_{i+k}$, with $k \geq 1$.

5. Combined logic signal sequence generator according to claim 4, characterized in that the logic checking means incorporates an input (INVALCOMB) for the control of the invalidation by control means (M1) of an initial combination of logic signals present on the N outputs of the combined logic signal generator (PM).

6. Combined logic signal sequence generator according to claim 5, characterized in that the logic checking means (C) also incorporates an input (EVENEXT) and an input (INHIB) for the control of bringing to logic level 0 of the output signals of the multiplexers, when at an instant $t_i$ the sequence of signals provided at this instant on the outputs of the multiplexers must not be used.

7. Combined logic signal sequence generator according to claim 3, characterized in that the checking means (C) incorporate means (VALCOL) for the recording of signals (VALCOL), which, combined with the signal supplied on the R outputs of the multiplexers (MX1 . . . . MXR) make it possible to invalidate any sequence not corresponding to a desired signal sequence on the outputs of the multiplexers.

# FIG.1

FIG.2

EP 0 170 568 B1

EP 0 170 568 B1

FIG.3B

FIG.3A

3

FIG. 3B

EP 0 170 568 B1